# EUROPÄISCHE PATENTANMELDUNG

(11) **EP 1 593 980 A1**
(43) Veröffentlichungstag der Anmeldung: **09.11.2005**
(21) Anmeldenummer: 05007012.7
(22) Anmeldetag: 31.03.2005
(51) Int. Cl.: G01R 21/133

(54) **Elektronischer Elektrizitätszähler**

(30) Priorität: 17.04.2004 DE 102004018734
(71) Anmelder: EMH Elektrizitätszähler GmbH & Co KG, 19243 Wittenburg (DE)
(72) Erfinder: Malek, Norbert, 21438 Thieshope (DE)
(74) Vertreter: Hauck, Graalfs, Wehnert, Döring, Siemons

(57) **Zusammenfassung**

Elektronischer Elektrizitätszähler (10), mit einem Meßwerk, dessen Ausgang mit einem Mikrorechner verbunden ist, wobei der Mikrorechner eine Stufe für die Berechnung von Zählwerten, ein an die Stufe angeschlossenes Tarifwerk, einen Ausgang für eine Anzeige und mindestens einen Eingang für Steuersignale und eine an das Tarifwerk angeschlossene Tarifschaltuhr aufweist, der Mittel zugeordnet sind zur Korrektur der Zeit, wobei mit einem Steuereingang des Eingangs des Mikrorechners ein Empfänger (15) für Datensätze satellitengeschützter Positionsbestimmungssysteme verbunden ist, der Mikrorechner eine Filterstufe aufweist, die aus den Datensätzen die Zeitinformation herausfiltert und ein Zeitsignal auf die Tarifschaltuhr gibt, mit dem die Tarifschaltuhr eingestellt oder synchronisiert wird.

## Beschreibung

Die Erfindung bezieht sich auf einen elektronischen Elektrizitätszähler nach dem Oberbegriff des Patentanspruchs 1.

Elektronische Elektrizitätszähler verwenden Analogdigitalwandler für Strom und Spannung sowie einen Mikrorechner zur Bestimmung der verbrauchten Energiemenge. Zu diesem Zweck enthält der Mikrorechner eine Stufe für die Berechnung der dem Netz entnommenen Energie sowie ein Tarifwerk. Die Berechnung des Energiemengenpreises ist naturgemäß tarifabhängig und der Tarif kann beliebig eingestellt werden. Es ist auch bekannt, in einem derartigen Zähler eine Tarifschaltuhr einzubauen, um zeitabhängige Tarifänderungen zu berücksichtigen. Bei derartigen elektronischen Elektrizitätszählern für Sondervertragsanwendungen oder Mehrtarifanwendungen ist bekannt, die Tarifschalthandlungen über Schaltuhren vorzunehmen. Der Zeitgeber der Tarifschaltuhr kann in den Mikrorechner integriert sein oder einen separaten Zeitgeber darstellen, der im Gehäuse des Elektrizitätszählers untergebracht ist.

Von der Funktion her bietet sich die Unterteilung einer derartigen Tarifschaltuhr in einen Zeitgeberteil (Echtzeituhr) und ein Schaltprogramm an. Eine Echtzeituhr bildet für einen bestimmten Anwendungsfall die Zeit und das Datum unter Berücksichtigung von Schaltjahren ab. Das Schaltprogramm wird zumeist in Form von Software realisiert. Der Zeitgeber benötigt zur Ermittlung der Zeit eine Zeitbasis. Diese ist üblicherweise ein Quarz. Bedingt durch Unzulänglichkeiten des Quarzes liegt die Schwingungsfrequenz des Quarzes nicht exakt auf einem theoretisch vorgegebenen Wert. Die Abweichungen der Schwingungsfrequenz unterliegen zudem der Exemplarstreuung, Temperaturänderungen und der Alterung. An die Ganggenauigkeit des Zeitgebers werden von seiten der Gerätebetreiber und auch von behördlicher Seite Anforderungen gestellt, die mit einem Standardquarz zu vertretbaren Kosten nicht erreicht werden. Zwar ist es möglich, bei einem Quarz einen Abgleich vorzunehmen, jedoch ist mit einem derartigen Abgleich lediglich die Exemplarstreuung der Quarze bei der Geräteinbetriebnahme während des Fertigungsprozesses zu kompensieren. Mit einem derartigen Abgleich ist der Fehler auf Minimalwerte möglich, jedoch ist die geforderte Genauigkeit nicht erreichbar. Zudem lassen sich Alterungs- und Temperatureinflüsse nicht wirtschaftlich vertretbar kompensieren.

Aus den angegebenen Gründen werden die Zeitgeber in Elektrizitätszählern von den Gerätebetreibern in wiederkehrenden Abständen korrigiert, an die Netzfrequenz gekoppelt oder mit Funkuhren (DCF 77) synchronisiert. Eine Kopplung des Zeitgebers an die Netzfrequenz bietet eine gute Langzeitstabilität, allerdings sind für manche Anwendungen die Abweichungen über große Zeiträume zu groß. Hinzu kommt, daß es Länder gibt, in denen die Netzfrequenz relativ schlecht geregelt ist, so daß sie als Zeitbasis nicht in Frage kommt. Alternativ läßt sich der Zeitgeber mit Hilfe eines externen Synchronsignals korrigieren. Dies geschieht üblicherweise über ein Modem und das Telefonnetz oder über das Internet (GPRS). Eine weitere Möglichkeit, den Zeitgeber zu synchronisieren, besteht darin, diesen mit einer "Funkuhr" zu verbinden. Die Funkuhr empfängt das Zeitzeichensignal, das vom Sender DCF 77 ausgestrahlt wird. Die abgestrahlte Zeitinformation entspricht der offiziellen Zeit der Bundesrepublik und hat die gewünschte Genauigkeit.

Es gibt verschiedene Möglichkeiten, den Zeitgeber im Elektrizitätszähler zu korrigieren:
- ein ferngesteuertes Gerät, z. B. ein Modem, sendet Synchronimpulse an den Zähler oder eine Funkuhr bildet die "amtliche" Zeit und schickt in regelmäßigen Abständen Synchronimpulse an den Zähler
- der Zähler bildet die gesendete Zeitinformation selber nach, indem er die demodulierten Impulse des Zeitzeichensenders interpretiert. Diese Lösung bietet den Vorteil, daß die Zeit des Zeitgebers immer korrekt ist, weil die vom Zeitzeichensender abgestrahlte Information direkt als Echtzeit verwendet werden kann, was beim Synchronisieren mittels Impulsen nicht der Fall ist.

Mit der zuerst beschriebenen Methode kann der Zeitgeber allerdings lediglich auf einen vorbestimmten Wert, z. B. eine volle Stunde, eine volle Minute usw., synchronisiert werden. Dieser Nachteil ist nur dadurch zu umgehen, daß dem Zeitgeber die gesamte Zeitinformation übermittelt wird.

In den Fällen, in denen gewünscht ist, die gesamte Zeitinformation an den Zähler zu schicken, weil beispielsweise betriebsbedingt der Zähler über längere Zeiträume abgeschaltet ist oder der Zeitgeber seine Zeitinformation verloren hat, weil der Energiespeicher des Zeitgebers leer ist oder ein wartungsfreier Betrieb des Zeitgebers gewünscht wird, bleibt nur die Möglichkeit, eine Funkuhr im Zähler vorzusehen. Nachteil der Funkuhr ist, daß die Ausbreitungsbedingungen des Zeitzeichensignals jahreszeitlichen und tageszeitlichen Schwankungen unterworfen sind und der Sender eine begrenzte Reichweite hat, wodurch die beschriebene Anwendung nicht an allen Standorten anwendbar ist.

Der Erfindung liegt die Aufgabe zugrunde, einen elektronischen Elektrizitätszähler zu schaffen, mit dem es möglich ist, die Tarifschaltuhr mit der gewünschten Genauigkeit zu betreiben.

Die Aufgabe wird erfindungsgemäß durch die Merkmale des Patentanspruchs 1 gelöst.

Bei dem erfindungsgemäßen Elektrizitätszähler ist ein Steuereingang des normalerweise vorhandenen Mikrorechners mit einem Empfänger für Datensätze satellitengestützter Positionsbestimmungssysteme verbunden. Derartige Positionsbestimmungssysteme werden z. B. bei Navigationssystemen bei Land- und Seefahrzeugen verwendet (GPS, GLONASS). Die zu diesen Systemen gehörenden Satelliten senden Signale, die unter anderem eine Zeitinformation enthalten. Diese ist zur Positionsbestimmung nötig, weil Signallaufzeiten für die Positionsbestimmungen verwendet werden. Die Satelliten verwenden als Zeitbasis sogenannte "Atomuhren", die aufgrund ihres Wirkungsprinzips eine hohe Stabilität und Genauigkeit aufweisen.

Bei dem erfindungsgemäßen elektronischen Elektrizitätszähler erhält mithin der Mikrorechner die Ausgangssignale eines Empfängers für ein derartiges System. Der Mikrorechner weist eine Filterstufe auf, die aus den Datensätzen des Empfängers die Zeitinformation herausfiltert und ein Zeitsignal auf die Tarifschaltuhr gibt. Mit Hilfe dieses Zeitsignals kann die Tarifschaltuhr eingestellt bzw. synchronisiert werden.

Es gibt standardisierte Empfangsgeräte für die Satellitensignale, z. B. eine sogenannte GPS-Maus. Die GPS-Maus empfängt die Signale eines oder mehrerer Satelliten und gibt die Daten in einem standardisierten Protokoll (z.B. NMEA 0183) ab. Bei der Erfindung kann nunmehr in der Filterstufe aus den Daten die Zeitinformation herausgefiltert und in der beschriebenen Art und Weise verwendet werden.

Nach einer Ausgestaltung der Erfindung ist der Empfänger des Empfangsgerätes in den elektronischen Elektrizitätszähler integriert, während eine Empfangsantenne außen am Zähler angebracht ist. Es versteht sich, daß die Antenne auch im Abstand zum Zähler angeordnet sein kann.

Die Erfindung wird nachfolgend anhand eines in Zeichnungen dargestellten Ausführungsbeispiels näher erläutert.
- Fig. 1: zeigt schematisch einen elektronischen Elektrizitätszähler mit einer Vorrichtung nach der Erfindung.
- Fig. 2: zeigt einen Teil der Vorrichtung nach der Erfindung, wie sie im Zähler nach Fig. 1 eingebaut ist.

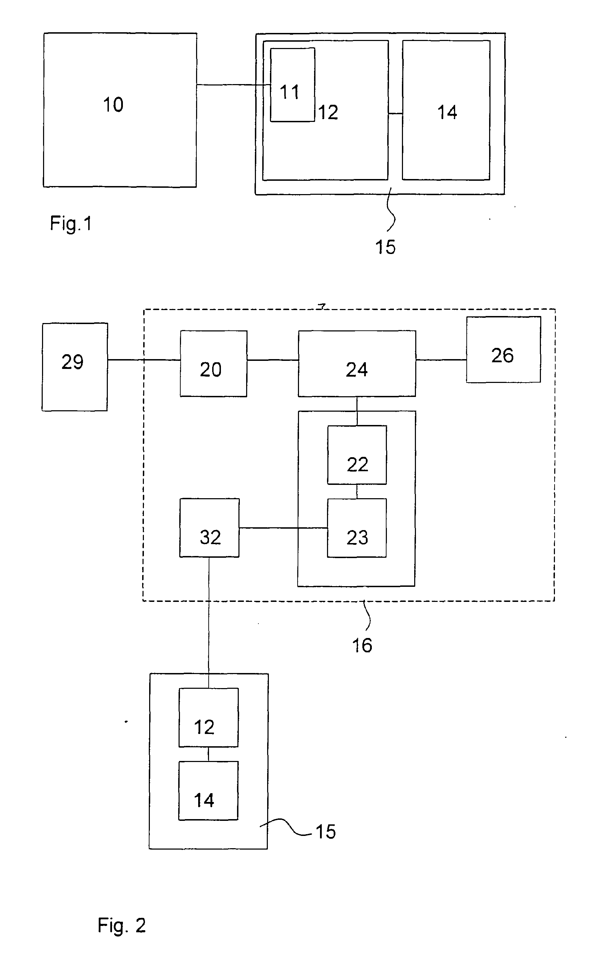

In Fig. 1 ist allgemein ein Gehäuse 10 für Elektrizitätszähler angedeutet. Der Anschluß des Zählers an das elektrische Netz ist nicht gezeigt. Der Elektrizitätszähler 10 enthält die üblichen Komponenten und Bauteile für die Messung der Energiemenge und weiterer Zählwerte, wie z. B. Leistungswerte. In Fig. 1 ist bei 15 ein Empfangsgerät für Satellitensignale zur Positionsbestimmung angedeutet (GPS oder Glosnass). Das Empfangsgerät 15 enthält einen Empfänger 12 und eine Antenne 14, die beide so konstruiert sind, daß sie die Signale der Satelliten eines Positionsbestimmungssystems empfangen können. Der Empfänger 12 stellt an einer Kommunikationsschnittstelle 11 ein Datentelegramm (z. B. gemäß NMEA 183) zur Verfügung, das unter anderem die Zeitinformation enthält. Das Datentelegramm wird über eine Drahtverbindung oder drahtlos an den Elektrizitätszähler 10 geleitet.

In Fig. 2 ist im gestrichelt gezeichneten Kasten 16 ein Mikrorechner für den Elektrizitätszähler nach Fig. 1 dargestellt. Er beinhaltet ein Tarifwerk 24, das mit dem Rechenwerk 20 und der Schaltuhr 16, bestehend aus Schaltprogramm 22 und Echtzeituhr 23, verbunden ist. Das Tarifwerk 24 registriert in unterschiedlichen Tarifen die Zählgrößen, die gemessen werden sollen und vom Rechenwerk 20 geliefert werden. Das Rechenwerk enthält seine Eingangsgrößen vom Meßwerk 29. Der Mikrorechner kann eine Anzahl von Ein- und Ausgängen aufweisen, die hier jedoch nicht gezeigt sind. Außerdem können weitere Funktionen integriert sein, die in diesem Falle jedoch nicht beschrieben werden sollen. Bei 26 ist eine Anzeige angedeutet, die die Zählwerte anzeigt. In Fig. 2 ist auch das Empfangsgerät nach Fig. 1 dargestellt. Das Ausgangssignal des Empfängers 12 wird auf eine Filterstufe 32 geleitet, die aus dem Datensatz der vom Empfänger gesendeten Satellitensignale eine Zeitinformation herausfiltert und an den Zeitgeber 23 der Tarifschaltuhr weitergibt zwecks Einstellung bzw. Synchronisierung der Zeit des Zeitgebers.

Mit Hilfe der gezeigten Vorkehrung ist es möglich, an jedem Ort der Erde in einem elektronischen Elektrizitätszähler einen präzise gehenden Zeitgeber vorzusehen, der den Anforderungen der Betreiber bzw. der zuständigen Behörden vollauf gerecht wird. Die hierfür aufzubringenden Mittel sind wenig aufwendig und können in jedem elektronischen Elektrizitätszähler, dessen Tarif zeitabhängig gesteuert wird, eingesetzt werden.

## Patentansprüche

1. Elektronischer Elektrizitätszähler, mit einem Meßwerk, dessen Ausgang mit einem Mikrorechner verbunden ist, wobei der Mikrorechner eine Stufe für die Berechnung von Zählwerten, ein an die Stufe angeschlossenes Tarifwerk, einen Ausgang für eine Anzeige und mindestens einen Eingang für Steuersignale und eine an das Tarifwerk angeschlossene Tarifschaltuhr aufweist, der Mittel zugeordnet sind zur Korrektur der Zeit, **dadurch gekennzeichnet, daß** mit einem Steuereingang des Mikrorechners (16) ein Empfänger (14, 12) für Datensätze satellitengeschützter Positionsbestimmungssysteme verbunden ist, der Mikrorechner (16) eine Filterstufe (32) aufweist, die aus den Datensätzen die Zeitinformation herausfiltert und ein Zeitsignal auf die Tarifschaltuhr (22) gibt, mit dem die Tarifschaltuhr (22) eingestellt oder synchronisiert wird.

2. Elektrizitätszähler nach Anspruch 1, **dadurch gekennzeichnet, daß** der Empfangsteil (12) in den Elektrizitätszähler (10) integriert ist, während eine Empfangsantenne (14) außen am Elektrizitätszähler (10) angebracht ist.

3. Elektrizitätszähler nach Anspruch 2, **dadurch gekennzeichnet, daß** der Empfänger drahtlos mit dem Mikrorechner (16) verbunden ist.

4. Elektrizitätszähler nach Anspruch 1 und 3, **dadurch gekennzeichnet, daß** das Empfangsgerät eine GPS-Maus ist.

5. Elektrizitätszähler nach einem der Ansprüche 1 bis 4, **dadurch gekennzeichnet, daß** die Filterstufe (32) an das standardisierte Protokoll des Empfängers angepaßt ist.
